# EUROPEAN PATENT APPLICATION

(11) **EP 4 592 754 A1**
(43) Date of publication of application: **30.07.2025**
(21) Application number: 23867811.4
(22) Date of filing: 18.05.2023
(51) Int. Cl.: G03F 7/32, B41C 1/00, B41N 1/00, G03F 7/00, G03F 7/033

(54) **METHOD FOR PRODUCING REGENERATED DEVELOPING LIQUID AND PHOTOSENSITIVE RESIN COMPOSITION SUITABLE FOR SAME**

(30) Priority: 21.09.2022 JP 2022150200
(71) Applicant: TOYOBO MC Corporation, Osaka 530-0001 (JP)
(72) Inventor: YOSHIMOTO, Kazuya, Okayama-shi, Okayama 704-8194 (JP)
(74) Representative: Müller-Boré & Partner Patentanwälte PartG mbB
(86) International application number: PCT/JP2023/018636
(87) International publication number: WO 2024/062680

(57) **Abstract**

The present invention aims to produce, from a waste developer of a water-developable flexographic printing original plate, a high-performance recycled developer regarding a developing speed and a problem of attachment of flocculate onto the surface of a printing plate. A method for producing a recycled developer from a waste developer generated by development of a water-developable flexographic printing original plate having a photosensitive resin layer composed of a photosensitive resin composition containing at least a hydrophobic polymer, a hydrophilic polymer, a photopolymerizable unsaturated compound, a photopolymerization initiator, and a plasticizer, wherein the method comprises the steps of:
leaving the waste developer to stand still in a tank without adding a flocculant to the waste developer so as to allow the photosensitive resin composition contained in the waste developer to emerge/flocculate; and
discharging floating flocculate from the tank so as to obtain a liquid remaining in the tank as a recycled developer, wherein
the photosensitive resin composition has a true density of 0.91 to 0.97 g/cm³ before photo-curing and contains a water-soluble compound in a ratio of 1.5 to 15 mass%.

## Description

### Technical Field

The present invention relates to a method for producing a high-performance recycled developer from a waste developer generated by development of a water-developable flexographic printing original plate, and a photosensitive resin composition for water-developable flexographic printing original plates suitable for such a method.

### Background Art

A flexographic printing original plate generally has a structure having, on a support, a photosensitive resin layer made from a photosensitive resin composition. Such a flexographic printing original plate is made into a flexographic printing plate, for example, by selectively exposing a photosensitive resin layer to UV light and developing the exposed photosensitive resin layer with an aqueous developer. By brushing etc. during the development, the photosensitive resin composition of an unexposed portion in the photosensitive resin layer is physically removed from the printing plate and dispersed or dissolved in the developer. When the development of the photosensitive resin layer is repeated using the identical developer, the concentration of the photosensitive resin composition dispersed in the developer is raised. As a result, the developing speed is lowered, and the dispersed photosensitive resin composition is flocculated and thus generates a flocculate. This flocculate reattaches to the surface of a printing plate and lowers the quality of the surface of the plate. Therefore, it is necessary to dispose of the developer having a high concentration of the photosensitive resin composition and restart a plate-making using a new replacement developer. However, the repetition of disposal of a used developer and replacement of the used developer with a new developer is not preferred in terms of environmental load and production costs. Therefore, removing the photosensitive resin composition from a used developer and reuses the developer is being attempted.

Patent Document 1 discloses a method for flocculating a resin component dispersed in a used developer by a flocculant and separating a flocculated resin solid content. The flocculant, however, is expensive, and the use of the flocculant is not preferred from the viewpoint of costs. Further, the developer having the flocculant added thereto exhibits considerably-low developing speed and there is therefore a fundamental problem that such a developer cannot be reused as a developer.

Patent Document 2 discloses a method for recycling a developer by flocculating a photosensitive resin composition with a specially dedicated disperse-material filter and further filtering a flocculate with another flocculate filter. In this method, however, the use of the specially dedicated disperse-material filter and the flocculate filter is essential, and troublesome work of maintaining the two filters has been required.

Patent Document 3 discloses a method for producing a recycled developer by treating a waste developer with a ceramic filter so as to remove an undissolved resin component in the waste developer. In this method, the number of filter needs to be only one. Also in this method, however, burden of maintenance has been large because backwashing of the filter has frequently been required so as to prevent clogging in the filter.

In order to solve the above problems of the conventional art, the present applicant has proposed, in Patent Document 4, a method in which a waste developer is left to stand still in a tank for a long time so as to allow a photosensitive resin composition dispersed in the waste developer to emerge/flocculate due to a difference in specific gravity from water mainly contained in the waste developer, and floating flocculate is discharged from the tank so as to use a liquid remaining in the tank as a recycled developer. This method makes it possible to easily obtain a recycled developer having a low solid matter concentration at a high recovery rate. However, a recent increase in the resolution of printed matter requires a method for producing a higher-performance recycled developer in terms of developing speed and a problem of re-attachment of flocculate onto the surface of a printing plate.

### Prior Art Document

### Patent Document

Patent Document 1: Japanese Patent Application Laid-Open (JP-A) No. 194824/94
Patent Document 2: Japanese Patent Application Laid-Open (JP-A) No. 2011-232407
Patent Document 3: WO 2018/061958
Patent Document 4: PCT/JP2022/9590

### Disclosure of the Invention

### Problem that the Invention is to Solve

The present invention has been conceived in light of the above circumstances of the conventional. An object of the present invention is to provide a method for producing, from a waste developer generated by development of a water-developable flexographic printing original plate, a high-performance recycled developer in terms of developing speed and a problem of re-attachment of flocculate onto the surface of a printing plate, and a photosensitive resin composition for water-developable flexographic printing original plates suitable for such a method.

### Means for Solving the Problem

In order to achieve the above object, the present inventor has intensively studied a photosensitive resin composition used for printing original plates to be developed, and as a result has found that when a recycled developer is produced by a static method, a high solid matter recovery rate can be achieved so that a recycled developer can be obtained which exhibits a high developing speed and hardly causes a problem of re-attachment of flocculate onto the surface of a printing plate, by using a photosensitive resin composition having a true density within a specific range and allowing the photosensitive resin composition to contain a water-soluble compound in a ratio within a specific range.

Thus, the present invention is completed based on the above findings and is constituted from the following (1) to (6).
(1) A method for producing a recycled developer from a waste developer generated by development of a water-developable flexographic printing original plate having a photosensitive resin layer composed of a photosensitive resin composition containing at least a hydrophobic polymer, a hydrophilic polymer, a photopolymerizable unsaturated compound, a photopolymerization initiator, and a plasticizer, wherein the method comprises the steps of:
   leaving the waste developer to stand still in a tank without adding a flocculant to the waste developer so as to allow the photosensitive resin composition contained in the waste developer to emerge/flocculate; and
   discharging floating flocculate from the tank so as to obtain a liquid remaining in the tank as a recycled developer, wherein
   the photosensitive resin composition has a true density of 0.91 to 0.97 g/cm³ before photo-curing and contains a water-soluble compound in a ratio of 1.5 to 15 mass%.
(2) The method according to (1), wherein the photosensitive resin composition has a true density of 0.93 to 0.99 g/cm³ after photo-curing.
(3) The method according to (1), wherein the water-soluble compound is a water-soluble photopolymerizable unsaturated compound selected from the group consisting of one having polyalkylene glycol in its structure, one containing a carboxyl group in its molecule, one containing a hydroxyl group in its molecule, one containing an amino group in its molecule, and a mixture of them.
(4) A method for producing a water-developable flexographic printing plate, wherein the method comprises using, as a developer, the recycled developer obtained by the method according to any one of (1) to (3).
(5) A photosensitive resin composition for water-developable flexographic printing original plate containing at least a hydrophobic polymer, a hydrophilic polymer, a photopolymerizable unsaturated compound, a photopolymerization initiator, and a plasticizer, wherein the photosensitive resin composition has a true density of 0.91 to 0.97 g/cm³ before photo-curing and contains a water-soluble compound in a ratio of 1.5 to 15 mass%.
(6) A water-developable flexographic printing original plate having a support and a photosensitive resin layer, wherein the photosensitive resin layer is composed of the photosensitive resin composition for water-developable flexographic printing original plate according to (5).

### Effects of the Invention

According to the method of the present invention, it is possible to produce, from a waste developer generated by development of a water-developable flexographic printing original plate, a high-performance recycled developer that achieves a high developing speed and hardly causes a problem of re-attachment of flocculate onto the surface of a printing plate because a photosensitive resin composition having a true density within a specific range is used and the photosensitive resin composition contains a water-soluble compound in a ratio within a specific range.

### Brief Description of the Drawings

FIG. 1 illustrates one example of a developing device of a water-developable flexographic printing original plate which can be used in a method according to the present invention.
FIG. 2 illustrates one example of the shape of an outlet formed on a side surface of a tank which can be used in the method according to the present invention.
FIG. 3 illustrates another example of the shape of an outlet formed on a side surface of a tank which can be used in the method according to the present invention.
FIG. 4 illustrates one example of an outlet formed on a side surface of a tank which can be used in the method according to the present invention, wherein the outlet has a lid and the lid is in a closed state.
FIG. 5 illustrates one example of an outlet formed on a side surface of a tank which can be used in the method according to the present invention, wherein the outlet has a lid and the lid is in an opened state.

### Mode for Carrying Out the Invention

The method for producing a recycled developer from a waste developer of a water-developable flexographic printing original plate and the photosensitive resin composition used for the method will be illustrated hereinafter in detail.

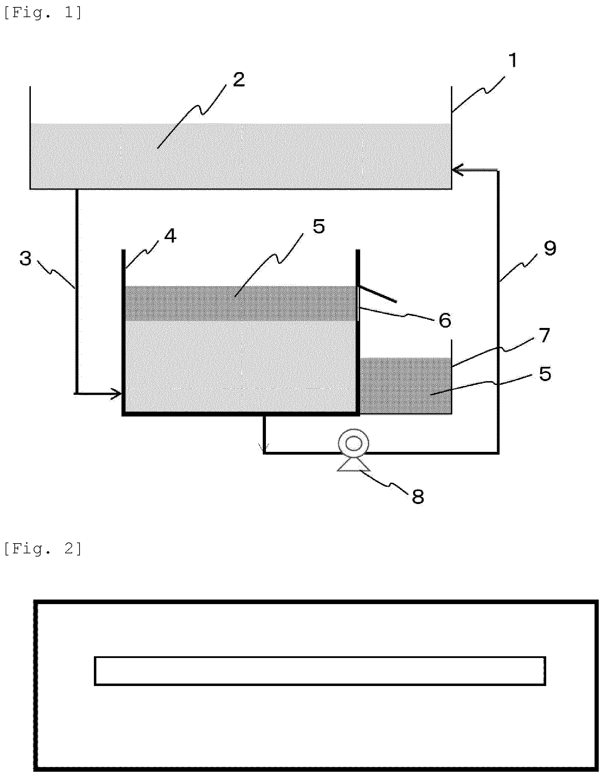

First, FIG. 1 illustrates one example of a developing device of a water-developable flexographic printing original plate used in a method according to the present invention. In FIG. 1, 1 represents a developing bath, in which is stored a developer 2 used in development of a flexographic printing original plate. A pipe is represented by 3, and a developer having a high concentration of a photosensitive resin composition as a result of repetitive development is, as a waste developer, transferred from the developing bath 1 to a stationary tank 4 via the pipe 3. FIG. 1 illustrates a state of the waste developer left to stand still in the stationary tank 4. Particles of a flocculate 5 are emerged and gathered to the above and a solid-liquid mixed phase containing the flocculate is formed beneath the liquid surface of the waste developer. An outlet represented by 6 is formed on a side surface of the stationary tank 4. For example, the solid-liquid mixed phase containing the flocculate 5 is discharged from the outlet 6 to a flocculate recovery tank 7. A pump is represented by 8. A recycled developer wherein the flocculate 5 has been removed therefrom and thus a concentration of solid content has been lowered is returned to the developing bath 1 via a pipe 9 by the pump 8.

FIG. 1 illustrates an aspect of providing a stationary tank as the tank and transferring a waste developer from a developing bath to the stationary tank. Providing a stationary tank other than a developing bath as described above causes advantages that next development can be performed during leaving a waste developer to stand still and that a solid matter separated from the waste developer left to stand still is never deposited on a brush or the like immersed in the liquid in the developing bath. The present invention, however, is not limited to this aspect. For example, the developing bath may be configured similarly to the stationary tank so as to perform in the developing bath the same steps as the steps performed in the stationary tank. In the present invention, the stationary tank or the developing bath configured above can be used as a tank for leaving a waste developer to stand still in producing a recycled developer from a waste developer.

In the method for producing a recycled developer according to the present invention, the waste developer used as a raw material is generated by development of a water-developable flexographic printing original plate. The water-developable flexographic printing original plate has a basic configuration having a support and a photosensitive resin layer provided on the support, wherein the photosensitive resin layer is composed of a photosensitive resin composition containing at least a hydrophobic polymer, a hydrophilic polymer, a photopolymerizable unsaturated compound, a photopolymerization initiator, and a plasticizer. In the present invention, the support is not limited, and any conventionally-known one may be used.

The present invention is characterized in that a photosensitive resin composition used to form a photosensitive resin layer of a printing original plate has a true density of 0.91 to 0.97 g/cm³ before photo-curing and contains a water-soluble compound in a ratio of 1.5 to 15 mass%. A developer used for development of water-developable flexographic printing original plates is a water-based developer mainly containing water. The true density (specific gravity) of water is 1.0 g/cm³ at ordinary temperature. Therefore, the fact that the true density of the photosensitive resin composition before photo-curing is 0.91 to 0.97 g/cm³ means that the unexposed and non-photocured photosensitive resin composition is lighter than water mainly contained in the water-based developer used for development of printing original plates. Here, the waste developer generated by development of printing original plates contains, as solid matter, water-insoluble particles derived from the photosensitive resin composition in an unexposed and non-photocured area of the photosensitive resin layer removed from the printing plate. Therefore, when the waste developer is left to stand still, the water-insoluble particles contained, as solid matter, in the waste developer and derived from the unexposed and non-photocured photosensitive resin composition emerge due to a difference in specific gravity from water and flocculate. By removing such floating flocculate, the waste developer can be regenerated as a developer.

The upper limit of true density of the photosensitive resin composition before photo-curing needs to be 0.97 g/cm³, preferably be 0.96 g/cm³, more preferably be 0.95 g/cm³. If the true density before photo-curing exceeds the above upper limit, the difference in specific gravity from water mainly contained in the waste developer is reduced, and therefore there is a fear that the photosensitive resin composition is less likely to emerge/flocculate so that the stationary time of the waste developer increases, which is not practical. Further, the photosensitive resin composition may remain in a recycled developer without being recovered, which causes attachment of the photosensitive resin composition onto the surface of a printing plate. On the other hand, the lower limit of true density of the photosensitive resin composition before photo-curing needs to be 0.91 g/cm³, preferably be 0.92 g/cm³, more preferably be 0.93 g/cm³. If the true density before photo-curing is less than the above lower limit, the photosensitive resin composition emerges too fast, and therefore there is a fear that the photosensitive resin composition emerges and flocculates as early as during development of printing original plates so that flocculate derived from the photosensitive resin composition removed by development is reattached onto the surface of the printing plate.

It should be noted that the term "true density" used in the present invention refers to a density calculated using only a volume occupied by a material itself as a volume for calculating a density, and is therefore suitable for the photosensitive resin composition because the volume of pores and internal voids are not included. Specifically, the true density can be measured by placing the photosensitive resin composition in a Gay-Lussac pycnometer in such a manner that air in voids in the sample is completely removed by replacement with a liquid and calculating the relationship between the weight and the volume. The true density of the photosensitive resin composition can be controlled by adjusting the density and blending ratio of each of components constituting the photosensitive resin composition (e.g., a hydrophobic polymer, a hydrophilic polymer, a photopolymerizable unsaturated compound, a photopolymerization initiator, and a plasticizer). Specifically, a desired true density can be achieved by finely adjusting an average density determined by calculation from the density and percentage of each of components constituting the photosensitive resin composition while comparing the average density with a true density actually measured by a method that will be described later in Examples.

The present invention specifies that the true density "before" photo-curing is within a specific range (0.91 to 0.97 g/cm³). This specific range is a numerical range set in consideration also with the true density "after" photo-curing. The present inventor has found that when the photosensitive resin composition constituting a photosensitive resin layer in an exposed area of a printing original plate is photo-cured by exposure of the printing original plate, the volume of the resin composition is slightly contracted so that the true density of the resin composition is slightly (about 0.02 g/cm³) increased. The reason why the upper limit of the true density "before" photo-curing is set to "0.97 g/cm³" in the present invention is that when the upper limit is set to such a value, the true density "after" photo-curing becomes about "0.99 g/cm³" which is still lower than the specific gravity of water mainly contained in the developer, and therefore when the waste developer is left to stand still, water-insoluble particles contained, as solid matter, in the waste developer and derived from the resin composition in an exposed area emerge and flocculate and are then removed.

Heretofore, attention has been paid, as water-insoluble solid matter in a waste developer, only to water-insoluble solid matter derived from a non-photocured photosensitive resin composition in a photosensitive resin layer in an unexposed area of a printing original plate scrubbed off with a brush or the like during development. On the other hand, in the present invention, attention is paid to the fact that a waste developer may contain, not only a non-photocured photosensitive resin composition in a photosensitive resin layer in an unexposed area of a printing original plate, but also part of a photo-cured photosensitive resin composition in the photosensitive resin layer in an exposed area of the printing original plate scrubbed off with a brush or the like during development. Specifically, even when halftone dots are formed on a printing original plate by exposure and photo-curing, halftone dots having a weak three-dimensional shape due to insufficient photo-curing are scrubbed off from the plate by brushing or the like during development and flow into a developer. Particularly, due to a recent increase in the resolution of printed matter, there is a growing demand for production of printing plates having small halftone dots. However, it is difficult to form small halftones on a printing original plate with high accuracy, and as a result, halftone dots having a weak three-dimensional shape due to insufficient photo-curing are scrubbed off from the plate by brushing or the like during development and flow into a developer so that such halftone dots are present as water-insoluble solid matter in a waste developer. Such water-insoluble solid matter is derived from a photosensitive resin composition "after" photo-curing, and is therefore, as described above, larger in true density than water-insoluble solid matter derived from a photosensitive resin composition "before" photo-curing to which attention has heretofore been paid. Therefore, the true density "after" photo-curing is preferably taken into consideration so as to more reliably remove also the water-insoluble solid matter derived from a photosensitive resin composition "after" photo-curing by allowing it to emerge and flocculate when a waste developer is left to stand still. Also in consideration of this, the upper limit (0.97 g/cm³) of the true density "before" photo-curing specified in the present invention is set. It should be noted that in the present invention, the true density of a photosensitive resin composition "after" photo-curing was measured using an evaluation sheet produced from the photosensitive resin composition to have a 500 µm-thick photosensitive resin layer whose both surfaces were covered with polyester films and exposed to ultraviolet light in such a manner that the amount of exposure to UV (accumulated light amount) was 1000 mJ. It should be noted that the amount of exposure to UV can be measured by an accumulated UV meter.

Hereinbelow, a description will be made about the other characteristic of the present invention that the photosensitive resin composition used to form a photosensitive resin layer of a printing original plate contains a water-soluble compound in a ratio of 1.5 to 15 mass%. The characteristic that "the true density before photo-curing is 0.91 to 0.97 g/cm³" having been previously described is intended to address a problem resulting from a "water-insoluble" compound that is one of components constituting the photosensitive resin composition (re-attachment of flocculate generated by flocculation of the "water-insoluble" compound (solid matter) onto the surface of a printing plate). On the other hand, the other characteristic is intended to address a problem resulting from a "water-soluble" compound that is one of components constituting the photosensitive resin composition. Many of components constituting the photosensitive resin composition (e.g., a hydrophobic polymer, a hydrophilic polymer, a photopolymerizable unsaturated compound, a photopolymerization initiator, and a plasticizer) are "water-insoluble" compounds, but a "water-soluble" compound is sometimes used. For example, as the photopolymerizable unsaturated compound, a "water-soluble" photopolymerizable unsaturated compound is sometimes used so as to reduce a developing time. The present inventor has found that when a printing original plate is obtained using a photosensitive resin composition containing a large amount of such a "water-soluble" photopolymerizable unsaturated compound, a large amount of the photopolymerizable unsaturated compound remains "water-soluble" in an unexposed area of a photosensitive resin layer without being photo-cured, that is, without being photopolymerized, and is therefore eluted into a developer due to development using a water-based developer, which reduces the developing speed of a waste developer. Therefore, from the viewpoint of balance between a reduction in developing time and an increase in the developing speed of a waste developer, it is preferred that the photosensitive resin composition does not contain a "water-soluble" photopolymerizable unsaturated compound too much. Based on such a finding, in the present invention, the content of a water-soluble compound in the photosensitive resin composition is limited to a specific range of 1.5 to 15 mass%. It should be noted that the "water-soluble" compound in the photosensitive resin composition is not limited to the above-described photopolymerizable unsaturated compound. For example, some hydrophilic polymers contain a "water-soluble" component as part thereof, and these hydrophilic polymers cause the same problem as the "water-soluble" photopolymerizable unsaturated compound. Further, a commercially-available "water-soluble" photopolymerizable unsaturated compound may contain a small amount of an unreacted material or a partial reaction product generated by an imperfect reaction, and these unreacted material and partial reaction product also cause the same problem as the "water-soluble" photopolymerizable unsaturated compound. Therefore, in the present invention, the content of a water-soluble compound including these hydrophilic polymer, unreacted material, and partial reaction product is limited to a specific range.

In the present invention, the upper limit of content of the water-soluble compound in the photosensitive resin composition needs to be 15 mass%, preferably be 12 mass%, more preferably be 10 mass%, further preferably be 7 mass%, especially preferably be 5 mass%. If the content of the water-soluble compound in the photosensitive resin composition exceeds the above upper limit, there is a fear that a large amount of the water-soluble compound in an unexposed area of the photosensitive resin composition is eluted into a developer due to development using a water-based developer so that the developing speed of a waste developer reduces. On the other hand, the lower limit of content of the water-soluble compound in the photosensitive resin composition needs to be 1.5 mass%, preferably be 1.8 mass%, more preferably be 2.0 mass%, especially preferably be 2.2 mass%. If the content of the water-soluble compound in the photosensitive resin composition is less than the above lower limit, there is a fear that the effect of reducing the developing time of a printing original plate is poor. The content of the water-soluble compound in the photosensitive resin composition can be controlled by adjusting the water-soluble compound content and blending ratio of each of components constituting the photosensitive resin composition (e.g., a hydrophobic polymer, a hydrophilic polymer, a photopolymerizable unsaturated compound, a photopolymerization initiator, and a plasticizer). Specifically, a desired content of the water-soluble compound in the photosensitive resin composition can be achieved by finely adjusting an average water-soluble compound content determined by calculation from the water-soluble compound content and percentage of each of components constituting the photosensitive resin composition while comparing the average water-soluble compound content with a content of the water-soluble compound in the photosensitive resin composition actually measured by a method that will be described later in Examples. When the water-soluble compound is a photopolymerizable unsaturated compound, it is possible to use any water-soluble photopolymerizable unsaturated compound conventionally used so as to reduce a developing time. Such a water-soluble photopolymerizable unsaturated compound may be one selected from the group consisting of a photopolymerizable unsaturated compound having polyalkylene glycol in its structure, a photopolymerizable unsaturated compound containing a carboxyl group in its molecule, a photopolymerizable unsaturated compound containing a hydroxyl group in its molecule, a photopolymerizable unsaturated compound containing an amino group in its molecule, and a mixture of them. Specific examples of the photopolymerizable unsaturated compound having polyalkylene glycol in its structure include polyethylene glycol di(meth)acrylates such as diethylene glycol di(meth)acrylate, triethylene glycol di(meth)acrylate, and tetraethylene glycol di(meth)acrylate. Specific examples of the photopolymerizable unsaturated compound having a hydroxyl group in its molecule include (meth)acrylates of polyhydric alcohols such as 2-hydroxyethyl (meth)acrylate, 2-hydroxypropyl (meth)acrylate, and glycerin mono (meth) acrylate. Specific examples of the photopolymerizable unsaturated compound containing an amino group in its molecule include N,N-dimethylaminoethyl methacrylate, dimethylaminoethyl acrylate, diethylaminoethyl methacrylate, diethylaminoethyl acrylate, and dimethylaminomethyl methacrylate. It should be noted that the term "compound" used in the present invention includes not only a high-molecular-weight polymer such as a resin but also a low-molecular-weight oligomer or monomer. The term "compound" used in the present invention is not limited by its form and includes a liquid, a semi-solid, and a solid. Specifically, the hydrophobic polymer, the hydrophilic polymer, the photopolymerizable unsaturated compound, and the plasticizer correspond to the "compound" in the present invention, and an organic compound blended in addition to these components is also included in the "compound". In the present invention, the water-soluble compound refers to a compound soluble in water, and water-soluble means that when mixed with water at 25°C with stirring, a compound is dissolved in water to form a transparent solution. The amount of the water-soluble compound in the photosensitive resin composition is the total amount of all the water-soluble compounds contained in the photosensitive resin composition. The water-soluble compound content of the photosensitive resin composition can be determined by measuring the mass of compounds dissolved in water at 25°C by mixing with stirring in a water solubility test and calculating the ratio of the mass of the compounds dissolved in water to the mass of the photosensitive resin composition used for the water solubility test. On the other hand, the "water-insoluble" compound refers to a compound that does not dissolve in water when mixed with water, or a (water-dispersible) compound that forms a translucent or milky white liquid when mixed with water. Specifically, "water-insoluble" means that a compound does not dissolve or forms a translucent or milky white liquid (disperses in water) when mixed in an amount of 10 mass% with water at 25°C with stirring. It should be noted that when a compound is dissolved to form a transparent solution, the solution is filtered through a cylindrical funnel-type glass filter (pore size: 16 µ to 40 µ, manufactured by SHIBATA SCIENTIFIC TECHNOLOGY LTD.) so as to confirm the absence of an insoluble compound.

Considering the requirements that the photosensitive resin composition used in the method of the present invention should satisfy, a detailed description will be made below about each of components (e.g., a hydrophobic polymer, a hydrophilic polymer, a photopolymerizable unsaturated compound, a photopolymerization initiator, and a plasticizer) constituting the photosensitive resin composition that can be used in the method of the present invention.

### (Hydrophobic polymer)

In the present invention, the term "hydrophobic polymer" refers to a polymer obtained by polymerization of a conjugated diene. The hydrophobic polymer is a main component constituting the photosensitive resin composition together with a hydrophilic polymer. Specific examples of the hydrophobic polymer include a polymer obtained by polymerization of a conjugated diene-based hydrocarbon and a copolymer obtained by copolymerization of a conjugated diene-based hydrocarbon and a monoolefin-based unsaturated compound. Examples of such a polymer and such a copolymer include a butadiene polymer, an isoprene polymer, a chloroprene polymer, a styrene-butadiene copolymer, a styrene-butadiene-styrene copolymer, a styrene-isoprene copolymer, a styrene-isoprene-styrene copolymer, a styrene-chloroprene copolymer, an acrylonitrile-butadiene copolymer, an acrylonitrile-isoprene copolymer, a methyl methacrylate-butadiene copolymer, a methyl methacrylate-isoprene copolymer, an acrylonitrile-butadiene-styrene copolymer, and an acrylonitrile-isoprene-styrene copolymer. Among them, a butadiene polymer is preferably used from the viewpoint of characteristics as a flexographic printing plate, i.e., the rebound resilience, strength-elongation properties, resin plate hardness, and shape stability before exposure of the surface of a printing plate or commercial availability. These hydrophobic polymers may be used singly or in combination of two or more of them. In the present invention, the hydrophobic polymer may be in the form of fine particles, and a polymer obtained from a water-dispersed latex may be used. Various synthesized latexes are commercially available as water-dispersed latexes, and therefore a desired water-dispersed latex may appropriately be obtained from them. When a water-dispersed latex is used, the water-dispersed latex may directly be added or may be dried so as to remove moisture and then added as a solid resin. The content of the hydrophobic polymer in the photosensitive resin composition forming a photosensitive resin layer is preferably in the range of 10 to 45 mass%.

### (Hydrophilic polymer)

In the present invention, the term "hydrophilic polymer" refers to a polymer containing a unit (monomer unit) derived from an unsaturated monomer containing, in its molecule, at least one hydrophilic functional group, such as carboxylic acid, sulfonic acid, phosphoric acid, or polyalkylene glycol and a conjugated diene-based monomer. The solubility of the hydrophilic polymer in water is preferably water-dispersible from the viewpoint of ease of separation and recovery. From a production viewpoint, the hydrophilic polymer is preferably a polymer obtained by removing water from a water-dispersed latex. Such a polymer is, for example, a polymer obtained by removing water from a water-dispersed latex in which polymer particles are dispersed in water, wherein the polymer particles have been obtained by emulsion polymerization of a unit derived from a hydrophilic unsaturated monomer and a conjugated diene-based monomer and another optional monomer copolymerizable therewith. From the viewpoint of developability, the hydrophilic functional group in the hydrophilic polymer is preferably a carboxyl group. The carboxyl group may be in the form of a salt of a metal such as sodium, potassium, or the like. From the viewpoint of ink resistance of a printing plate, the hydrophilic polymer may be in the form of internally cross-linked polymer particles, and from the viewpoint of ease of emergence/flocculation, the degree of gelation of the hydrophilic polymer as an indicator of internal crosslinking is preferably 10 to 90%. The content of the hydrophilic polymer in the photosensitive resin composition forming a photosensitive resin layer is preferably in the range of 10 to 45 mass%.

It should be noted that the value of degree of gelation of the hydrophilic polymer is here specified by insolubility in toluene. Specifically, the degree of gelation is measured in the following manner. In the case of a water-dispersed latex, a latex solution is spread on a PET film having a thickness of 100 µm and dried at 100°C for 1 hour to take out 1 g of a hydrophilic polymer. The obtained hydrophilic polymer is immersed in a toluene solution at 25°C for 48 hours, and then insoluble matter is separated with a filter and dried at 110°C for 2 hours to measure its weight after drying. The degree of gelation is calculated as percent by mass by dividing the weight of the dried insoluble matter by the weight of the hydrophilic polymer before immersion in a toluene solution.

The hydrophilic polymer is preferably in the form of particles. The average particle diameter thereof is preferably 400 nm or less, especially preferably 150 nm or less. If the average particle diameter is too large, water-developability of a printing original plate to be obtained may be reduced. The hydrophilic polymer may be a polymer obtained from a publicly-known water-dispersed emulsion. Specific examples of the latex include a carboxyl group-containing butadiene latex disclosed in JP 1-300246 A, JP 61-128243 A, and JP 6-194837 A, an amino group-containing diene-based polymer disclosed in JP 7-134411 A, and a styrene butadiene latex synthesized using a reactive emulsifier disclosed in Japanese Patent No. 3836433. Among them, from the viewpoint of water-developability and the physical properties of a printing plate, a carboxyl group-containing butadiene latex and a carboxyl group-containing styrene butadiene latex are preferred.

### (Photopolymerizable unsaturated compound)

In the present invention, as described above, a specific amount of a "water-soluble" photopolymerizable unsaturated compound particularly needs to be used so as to balance a reduction in developing time with an increase in the developing speed of a waste developer. However, in the present invention, it is not necessary to use only the "water-soluble" photopolymerizable unsaturated compound. Instead, a "water-insoluble" photopolymerizable unsaturated compound is preferably used in combination with the "water-soluble" photopolymerizable unsaturated compound. The photopolymerizable unsaturated compound may be a conventionally-known one used for printing original plates. Examples of such a photopolymerizable unsaturated compound include, but are not limited to, a photopolymerizable oligomer and a photopolymerizable monomer. These photopolymerizable unsaturated compounds may be used singly or in combination of two or more of them. The content of the photopolymerizable unsaturated compound in the photosensitive resin composition forming a photosensitive resin layer is preferably in the range of 1 to 50 mass%.

The photopolymerizable oligomer is a polymer in which an ethylenic unsaturated group is bonded to the terminal and/or side chain of a conjugated diene-based polymer and which has a number-average molecular weight of 1000 or more and 10000 or less. The conjugated diene-based polymer constituting the conjugated diene-based ethylenic polymer is constituted from a homopolymer of a conjugated diene unsaturated compound or a copolymer of a conjugated diene unsaturated compound and a monoethylenic unsaturated compound. Examples of such a copolymer include a butadiene polymer, an isoprene polymer, an acrylonitrile-butadiene copolymer, an acrylonitrile-isoprene copolymer, a methyl methacrylate-isoprene copolymer, an acrylonitrile-isoprene copolymer, a methyl methacrylate-isoprene copolymer, a methyl acrylate-butadiene copolymer, and an acrylonitrile-butadiene-styrene copolymer. Among them, from the viewpoint of rubber elasticity and photo-curability, a butadiene polymer, an isoprene polymer, and an acrylonitrile-butadiene copolymer are preferred. A butadiene polymer and an isoprene polymer are especially preferred.

The photopolymerizable monomer is a photopolymerizable compound having a molecular weight of 500 or less and an ethylenic unsaturated group, and is preferably a compound having at least two ethylenic unsaturated groups at its terminal and/or side chain. Examples of the photopolymerizable monomer include a polyfunctional photopolymerizable monomer having two or more photopolymerizable unsaturated groups and a monofunctional photopolymerizable monomer having one photopolymerizable unsaturated group. Specific examples of the photopolymerizable monomer include hexamethylene di(meth)acrylate, ethylene glycol (meth)acrylate, diethylene glycol di(meth)acrylate, 1,4-butanediol di(meth)acrylate, 1,6-hexanediol di(meth)acrylate, 1,9-nonanediol di(meth)acrylate, glycerin di(meth)acrylate, triethylene glycol di(meth)acrylate, PEG#400 di(meth)acrylate, 1,3-butanediol dimethacrylate, neopentyl glycol di(meth)acrylate, PEG#200 di(meth)acrylate, 1,3-butanediol di(meth)acrylate, neopentyl glycol di(meth)acrylate, 1,10-decanediol di(meth)acrylate, di(meth)acrylate of ethylene oxide adduct of bisphenol A, trimethylolpropane tri(meth)acrylate, ethylene oxide-modified trimethylolpropane tri(meth)acrylate, Light Ester P-2M (trade name, manufactured by Kyoeisha Chemical Co., Ltd.), oligopropylene glycol di(meth)acrylate, polytetramethylene glycol di(meth)acrylate, tricyclodecane dimethanol di(meth)acrylate, a compound having 3 ethylenic unsaturated groups, such as tirmethylolpropane tri(meth)acrylate, glycerin tri(meth)acrylate, tri(meth)acrylate of 3-mol ethylene oxide adduct of pentaerythritol, or pentaerythritol tri(meth)acrylate, and a compound having 3 ethylenic unsaturated groups, such as pentaerithritol tetra(meth)acrylate or dipentaerythritol hexa (meth) acrylate. Among them, a compound having 3 ethylenic unsaturated groups is particularly preferred.

In the present invention, the photopolymerizable unsaturated compound may contain a monofunctional photopolymerizable monomer having one photopolymerizable unsaturated group so as to enhance the mechanical strength of a printing plate and so as to improve the printing durability of the printing plate. Such a monofunctional photopolymerizable monomer may be a commercially-available one. Specific examples of the monofunctional photopolymerizable monomer include: alkyl (meth)acrylates such as methyl (meth)acrylate, ethyl (meth)acrylate, propyl (meth)acrylate, butyl (meth)acrylate, isoamyl (meth)acrylate, 2-ethylhexyl (meth)acrylate, lauryl (meth)acrylate, and stearyl (meth)acrylate; cycloalkyl (meth)acrylates such as cylochexyl (meth)acrylate; halogenated alkyl (meth)acrylates such as chloroethyl (meth)acrylate and chloropropyl (meth)acrylate; alkoxyalkyl (meth)acrylates such as methoxyethyl (meth)acrylate, ethoxyethyl (meth)acrylate, and butoxyethyl (meth)acrylate; hydroxyl group-containing (meth)acrylates such as 2-hydroxyethyl (meth)acrylate, 2-hydroxypropyl (meth)acrylate, 2-hydroxybutyl (meth)acrylate, 3-chloro-2-hydroxypropyl (meth)acrylate, and β-hydroxy-β'-(meth)acryloyloxyethyl phthalate; amino group-containing (meth)acrylates such as dimethylaminoethyl methacrylate; cycloalkyl (meth)acrylates such as cyclohexyl (meth)acrylate; alkoxyalkyl (meth)acrylates such as methoxyethyl (meth)acrylate, ethoxyethyl (meth)acrylate, and butoxyethyl (meth)acrylate; phenoxyalkyl (meth)acrylates such as phenoxyethyl (meth)acrylate and nonylphenoxyethyl (meth)acrylate; and heterocycle-containing monofunctional photopolymerizable monomer such as isobornyl (meth)acrylate and cyclic trimethylolpropane formal (meth)acrylate. Among them, particularly preferred monofunctional photopolymerizable monomers are alkyl methacrylates, and particularly, liner alkyl methacrylates having 8 to 18 carbon atoms are preferred. The content of such an alkyl methacrylate in the photosensitive resin composition obtained from a water-dispersed latex is preferably 1 to 30 parts by mass, particularly preferably 3 to 20 parts by mass.

### (Photopolymerization initiator)

The photopolymerization initiator is contained in the photosensitive resin composition so as to photopolymerize the photopolymerizable unsaturated compound. Any photopolymerization initiator can be used as long as it can polymerize a polymerizable carbon-carbon unsaturated group by light. Among such photopolymerization initiators, one having a function of generating a radical by self-decomposition or hydrogen abstraction induced by light absorption is preferably used. Examples thereof include benzoin alkyl ethers, benzophenones, anthraquinones, benzyls, acetophenones, and diacetyls. These polymerization initiators may be used in combination of two or more of them. The photopolymerization initiator particularly preferably contains, as two compounds different in photosensitivity, a benzyl alkyl ketal-based compound and a benzophenone-based compound. The content of the photopolymerization initiator in the photosensitive resin composition forming a photosensitive resin layer is preferably in the range of 0.5 to 3.0 mass%.

### (Plasticizer)

The plasticizer is contained in the photosensitive resin composition so as to impart flexibility to the photosensitive resin composition. The plasticizer may be conventionally-known one used for printing original plates, but is preferably a water-insoluble or water-dispersible plasticizer that is liquid at room temperature. The plasticizer is preferably a polymer having a repeating unit derived from a conjugated diene compound, and may be a polymer having a hydrophilic group in at least one kind of repeating unit. Examples of the hydrophilic group include a carboxyl group, a sulfonic acid group, a hydroxyl group, and an amino group. Among them, a carboxyl group is preferred. Specific examples of the conjugated diene compound include butadiene, isoprene, and styrene, and the conjugated diene compound may be a copolymer of them. Specific examples thereof include liquid polybutadiene, liquid polyisoprene, a liquid styrene-butadiene copolymer, polybutadiene having a carboxyl group at its side chain or terminal, a styrene-butadiene copolymer having a carboxyl group at its side chain or terminal, polybutadiene having a carboxyl group at its side chain or terminal, and isoprene having a carboxyl group at its side chain or terminal.

In polybutadiene having a carboxyl group at its side chain or terminal, a styrene-butadiene copolymer having a carboxyl group at its side chain or terminal, polybutadiene having a carboxyl group at its side chain or terminal, or polyisoprene having a carboxyl group at its side chain or terminal, the carboxyl group may be in the form of a metallic salt. Particularly, the carboxyl group is preferably in the form of a metallic salt because a water-based developer is used for development in the method of the present invention. The metallic salt is preferably a salt of an alkali metal such as lithium, sodium, or potassium.

As to the plasticizer, a hydrocarbon oil such as paraffin oil, an ester compound such as an adipic acid ester, a sebacic acid ester, or a phthalic acid ester, a polyester such as an adipic acid-based polyester, or a phosphoric acid-based compound such as a phosphoric acid ester may be used in combination with the above-described polymer having a repeating unit derived from a conjugated diene compound. The content of the plasticizer in the photosensitive resin composition forming a photosensitive resin layer is preferably in the range of 3 to 20 mass%.

If necessary, the photosensitive resin composition of the present invention may contain, in addition to the above-described hydrophobic polymer, hydrophilic polymer, photopolymerizable unsaturated compound, plasticizer, and photopolymerization initiator, additives such as a hydrophilic compound, a UV absorber, a surface-tension modifier, a thermal polymerization inhibitor, a dye, a pigment, a perfume, and an antioxidant.

From the viewpoint of kneading using an extruder, the total content of the hydrophobic polymer and the hydrophilic polymer, the content of the photopolymerizable unsaturated compound, and the content of the photopolymerization initiator in the photosensitive resin composition used in the method of the present invention are preferably 40 to 95 mass%, 5 to 35 mass%, and 0.1 to 10 mass%, respectively. From the viewpoint of water-developability, the content ratio of the hydrophilic polymer is preferably 40 to 90 mass% when the total content of the hydrophobic polymer and the hydrophilic polymer is taken as 100 mass%.

Next, the developer which is an origin of the waste developer in the method of the present invention will be explained. The developer used in development of the water-developable flexographic printing original plate is an aqueous developer containing water as a main component. Specifically, a developer containing, in addition to water, an alkaline compound such as sodium hydroxide and sodium carbonate, and a surfactant is preferred. The alkaline compound is blended so as to set the pH of the developer to an alkaline range (preferably 8.0 to 11.0). The surfactant is blended so as to promote the dispersion of the photosensitive resin composition into water and maintain the dispersion state thereof. The concentration of the surfactant in the developer is 0.5 to 10 mass%. The developer may also contain an organic solvent or the like in such an extent that does not lower the solubility of the alkaline compound and the surfactant. The developer is preferred to be used at a developer temperature of 25°C to 50°C, and especially preferred to be used at a developer temperature of 35°C to 45°C.

Optimal examples of the surfactant include a sodium alkylnaphthalene sulfonate and a sodium alkylbenzene sulfonate. Other usable examples of the surfactant include an anionic surfactant containing a carboxylate, a sulfuric acid ester salt, a sulfonate, a phosphoric acid ester salt, or the like; a nonionic surfactant such as a polyethylene glycol chain-containing compound, a polyhydric alcohol derivative, and a sorbitan derivative; a cationic surfactant containing a primary to tertiary amine salt, a quaternary ammonium salt, or the like; and an ampholytic surfactant containing an amino acid or betaine hydrophilic group.

The method for developing a water-developable flexographic printing original plate is not particularly limited as long as it is a method enabling a relief image to be formed by washing out a photosensitive resin composition of a non-photocured portion in a printing plate using an aqueous developer. Examples of the method include a method for scrubbing out a photosensitive resin composition with a brush by a developer, and a method for scrubbing out a photosensitive resin composition of a non-photocured portion by spraying and a brush in combination. For such a brush, the diameter of a single yarn of a brush, the diameter of an implantation hole, and the pitch distance between implantation holes may be selected as appropriate. Specifically, a brush is preferred that has a pitch distance between implantation holes of 6 to 10 mm, a diameter of a hole for implanting a hair bundle of 5 to 8 mm, and a diameter of a single yarn of 160 to 200 µm**.** Generally, a developer is repetitively used by the developing method described above until the concentration of a photosensitive resin composition becomes higher than a specific level and the developing speed is lowered. The developer is thereafter called a waste developer. Thereafter, the waste developer is left to stand still, and then the photosensitive resin composition is separated therefrom. The developer before the stand-still separation is called a waste developer in the present invention. The present invention is a method for producing a recycled developer from the waste developer generated as described above. Hereinafter, this method is described in detail.

In the method according to the present invention, a waste developer is left to stand still in a tank 4 as shown in Fig. 1, without adding a flocculant. The waste developer contains a high-concentration photosensitive resin composition dispersed therein. The true density (specific gravity) of this photosensitive resin composition is controlled to be less than 1.0 as described above, and therefore this photosensitive resin composition is lighter than water which is a main component of an aqueous developer used in development of a water-developable flexographic printing original plate. Therefore, when the waste developer is left to stand still, particles of the photosensitive resin composition dispersed in the waste developer are emerged due to the difference in specific gravity and spatially brought close to each other. Then, the photosensitive resin composition a part of which has already been flocculated in the waste developer is further flocculated and a flocculate 5 is thus formed. As a result, the tank 4 realizes therein a separation state in which, as illustrated in FIG. 1, the flocculate 5 is present immediately beneath the liquid surface of the waste developer, and components (the aqueous developer containing water as a main component) constituting the waste developer, other than the flocculate are present beneath the flocculate. The flocculate 5 present immediately beneath the liquid surface of the waste developer is not actually present singly as the flocculate 5, but is present in a form of a solid-liquid mixed phase in which the flocculate 5 and the aqueous developer are mixed to each other. On a side surface of the tank 4, an outlet 6 for discharging the flocculate 5 is formed. In the present invention, by discharging, e.g. from the outlet 6 of the tank 4, the solid-liquid mixed phase formed beneath the liquid surface of the waste developer and containing the flocculate 5, the flocculate 5 is efficiently removed. As a result, a recycled developer having a low concentration of solid content can be obtained with a high recovery rate. It should be noted that in the present invention, the method for removing flocculate is not limited to discharge through the outlet provided in the side surface of the tank. For example, although inferior in removal efficiency, flocculate may be discharged through an outlet provided in the bottom surface of the tank, or flocculate may be overflowed by pouring water into the tank from above the tank, or flocculate may be recovered by scooping it with a ladle.

When the waste developer is left to stand still in the tank, it is important to stationarily leave the waste developer for a certain time without any stir. The stationary time is preferred to be 5 hours or more, and further preferred to be 8 hours or more. The upper limit of the stationary time is not particularly limited, but is at most 24 hours. With a sufficient stationary time ensured as described above, it is possible to emerge and flocculate most of the photosensitive resin composition contained in the waste developer due to the difference in specific gravity and securely form the solid-liquid mixed phase containing the flocculate beneath the liquid surface of the waste developer.

The tank is preferred to have a substantially rectangular parallelepiped shape, a substantially cubic shape, or a substantially cylindrical shape. Among these shapes, a substantially rectangular parallelepiped shape and a substantially cylindrical shape having a large surface-area ratio are preferred. Particularly, a substantially rectangular parallelepiped shape is preferred because it enables effective use of the space in the device and facilitates the discharge from the outlet.

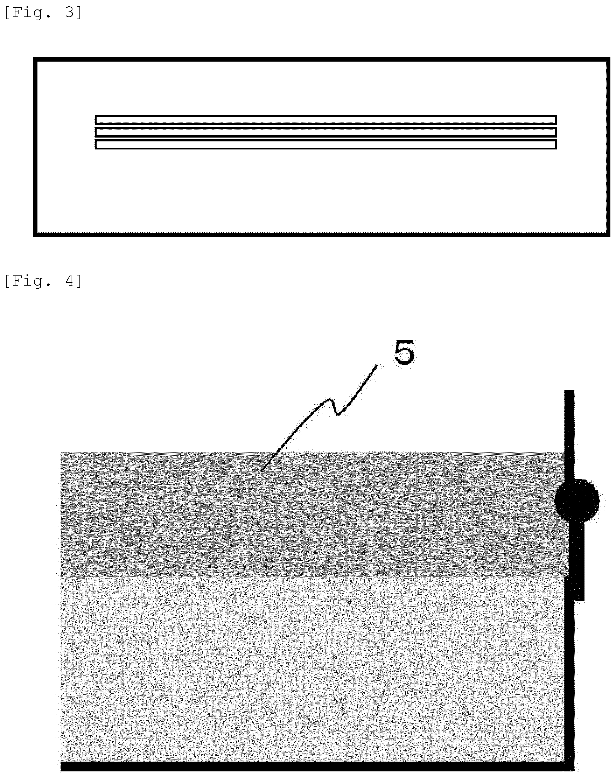

The outlet formed on the side surface of the tank is preferred to have a substantially circular shape, a substantially square shape, a substantially rectangular shape, or a slit shape. Among these shapes, a rectangle having the longitudinal direction thereof along the width direction of the tank as illustrated in FIG. 2 is particularly preferred in terms of facilitating separation. Alternatively, the outlet may have a plurality of slit shapes along the height direction as illustrated in FIG. 3. The outlet is preferred to have a height of 1 cm to 10 cm, and further preferred to be a height of 4 cm to 8 cm. The outlet having a smaller height than this range may easily cause clogging of the flocculate, and the outlet having a larger height may increase the discharge volume and may possibly lower the recovery rate. When the tank has a substantially rectangular parallelepiped shape or a substantially cubic shape, the maximum width of an aperture of the outlet is preferred to be 50% or more, and further preferred to be 85% or more of the maximum width of the tank. When the tank has a substantially rectangular parallelepiped shape or a substantially cubic shape, the maximum width of the tank means the larger one between the length and the width. When the tank has a substantially cylindrical shape, the length along the circumferential direction of the outlet is preferred to be 1/8 or more of the circumference of a horizontal sectional shape of the tank. By setting the maximum width and the length along the circumferential direction of the aperture of the outlet as described above, the discharge can smoothly be performed.

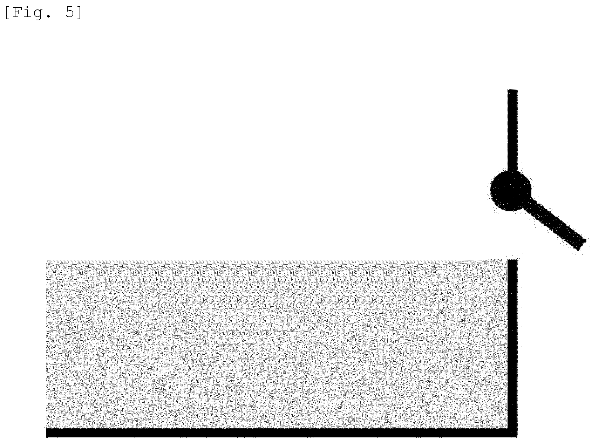

The outlet formed on the side surface of the tank is preferred to be provided with an openable lid as illustrated in FIGS. 4 and 5. When the liquid surface of the waste developer is above the outlet, the flocculate 5 floating immediately beneath the liquid surface of the waste developer can easily be separated and discharged by opening the lid that has been closed. The lid may have a structure in which the lid has a shape fitted to the outlet or in which something tabular is slid. A method for opening the lid is considered to be performed manually or electrically.

The position of the outlet of the tank is on the side surface of the tank. By setting the position of the outlet on the side surface, the flocculate floating immediately beneath the liquid surface of the waste developer can easily be separated. The lowest position of the aperture of the outlet is preferred to be at a height corresponding to 50% or more of the depth of the tank, and more preferred to be at a height corresponding to 55 to 90% of the depth of the tank. When the lowest position is set at a height of less than 50%, the difference in height from the level of the waste developer may be excessively large, whereby the discharge volume may be increased, the flocculate floating immediately beneath the liquid surface of the waste developer may be collapsed, and the concentration of solid content in the recycled developer may be raised.

The method according to the present invention can employ the following two discharge methods depending on the relationship between the position of the liquid surface of the waste developer after being left to stand still and the position of the outlet. First, when the level of the waste developer in the tank after the waste developer is left to stand still is higher than the lowest position of the aperture of the outlet, the flocculate floating immediately beneath the liquid surface of the waste developer can be separated and discharged from the outlet by opening the outlet. The level of the waste developer in the tank at the time of starting the discharge is preferred to be higher than the lowest position of the aperture of the outlet by a height corresponding to 3% or more of the depth of the tank, more preferred to be by a height corresponding to 5% or more of the depth of the tank, and further preferred to be by a height corresponding to 7% or more of the depth of the tank. When this difference in height is less than the above lower limit, the flocculate floating immediately beneath the liquid surface of the waste developer may not be sufficiently discharged and may possibly be left in the tank. The upper limit of this difference in height is preferred to be 30% or less, and more preferred to be 20% or less, and further preferred to be 15% or less. When this difference in height is more than the above upper limit, the discharge volume may be increased, whereby the flocculate floating immediately beneath the liquid surface of the waste developer may be collapsed, and the concentration of solid content in the recycled developer may be raised.

When the lowest position of the aperture of the outlet is at a height corresponding to 50% or more of the depth of the tank and the level of the waste developer in the tank at the time of starting the discharge is higher than the lowest position of the aperture of the outlet by a height corresponding to 3% or more of the depth of the tank, the tank has, for example, such a depth that the level of the waste developer in the tank at the time of starting the discharge is a height corresponding to 53% or more of the depth of the tank. Also for this case, the above description about the preferred range of the level of the waste developer in the tank at the time of starting the discharge is valid.

On the other hand, when the level of the waste developer in the tank after the waste developer is left to stand still is as high as or lower than the lowest position of the aperture of the outlet, the discharge cannot directly be performed. Therefore, after the photosensitive resin composition dispersed in the waste developer is emerged and flocculated by leaving the waste developer to stand still and the solid-liquid mixed phase containing the flocculate is formed beneath the liquid surface of the waste developer, water or a developer is transferred to the tank so as to raise the liquid surface of the waste developer to a level higher than the outlet. By opening the outlet in this state, the flocculate floating immediately beneath the liquid surface of the waste developer can be separated and discharged from the outlet. When water is transferred, it is desired to add a surfactant, a pH adjuster, or the like because the recycled developer is diluted with water and may possibly lower the developing speed. Regarding the level of the waste developer in the tank at the time of starting the discharge, also applicable to this case are the same conditions as when the level of the waste developer in the tank after the waste developer is left to stand still is higher than the lowest position of the aperture of the outlet.

In both the cases, at the time of discharging, from the tank, the flocculate floating immediately beneath the liquid surface of the waste developer by opening the outlet, flowing water may be injected from a nozzle, which is provided on a wall surface opposite to the outlet, toward the outlet so as to wash the flocculate away. Alternatively, the flocculate floating immediately beneath the liquid surface of the waste developer may be suctioned from the outlet. Considered as a suction method is, for example, a method for performing suctioning with a pump through a pipe connected to the outlet, or a method for using a vacuum cleaner for dry and wet use. The washing away and the suctioning make the discharge more quick and efficient.

The waste developer used as a raw material for producing the recycled developer is preferred to have a concentration of solid matter of 5.0 mass% or more, and more preferred to be 6.0 mass% or more, in terms of facilitating formation of the flocculate. This solid matter is mainly a compound derived from the water-insoluble photosensitive resin composition components contained in the waste developer.

In a configuration in which a stationary tank other than the developing bath is provided as a tank for leaving the waste developer to stand still, after the solid-liquid mixed phase containing the flocculate is separated and discharged from the stationary tank, a liquid left in the stationary tank can directly and/or indirectly be returned to the developing bath as the recycled developer and reused. In cases of indirectly returning the liquid, for example, a tank for recycled developer is provided in which the recycled developer is temporarily stored, and the recycled developer can be returned to the developing device as necessary. In cases of directly returning the liquid, the recycled developer can be returned to a developing section or a rinsing section of a developing machine.

According to the method of the present invention, it is possible to produce a high-performance recycled developer that achieves a high developing speed and hardly causes a problem of re-attachment of flocculate onto the surface of a printing plate because a photosensitive resin composition having a true density within a specific range is used and the photosensitive resin composition contains a water-soluble compound in a ratio within a specific range. Especially, in the recycled developer produced by the method according to the present invention, the condensate (flocculate) has been efficiently removed therefrom. Therefore, the recycled developer produced by the method according to the present invention has a concentration of solid matter as low as 3.5 mass% or less, and more preferred to be 3.0 mass% or less, and can maintain sufficient developing properties. This solid matter is mainly a compound derived from the water-insoluble photosensitive resin composition components contained in the recycled developer. Accordingly, the recycled developer obtained by the method according to the present invention can, without causing any problems, be used as a replacement of a normal developer in the production of a water-developable flexographic printing plate. In the method according to the present invention, the solid matter in the recycled developer can remarkably be decreased. Accordingly, separation of the flocculate with a filter is not particularly needed. However, when the recycled developer containing less solid matter is desired to be obtained stably by a continuous operation, the method may be performed in combination with filtration using a simple filter such as a nonwoven fabric.

### Examples

The effects of the method for producing a recycled developer according to the present invention are described by way of the following examples. The present invention, however, is not limited to these examples. In Examples and Comparative Examples, "part" and "percentage" are expressed on mass basis unless specifically designated. The measurement and the evaluation of performance in the Examples and Comparative Examples are performed by the following procedures.

### <True density of a photosensitive resin composition before and after photo-curing>

The true density of a photosensitive resin composition before photo-curing was determined by placing a sample of the photosensitive resin composition before photo-curing in a Gay-Lussac pycnometer in such a manner that air in voids in the sample was completely removed by replacement with a liquid and calculating the relationship between the weight and the volume. On the other hand, the true density of the photosensitive resin composition after photo-curing was determined by producing, from the photosensitive resin composition, an evaluation sheet having a 500 µm-thick photosensitive resin layer whose both surfaces were covered with polyester films, exposing the evaluation sheet to ultraviolet light in such a manner that the amount of exposure to UV (accumulated light amount) was 1000 mJ so as to prepare a sample, placing the sample in a Gay-Lussac pycnometer in such a manner that air in voids in the sample was completely removed by replacement with a liquid, and calculating the relationship between the weight and the volume.

### <Content of water-soluble compound in photosensitive resin composition>

The content of a water-soluble compound in a photosensitive resin composition was determined by performing a water solubility test in such a manner that the photosensitive resin composition was mixed with water at 25°C with stirring and performing a calculation according to the following formula. In the formula, the mass of the water-soluble compound remaining after drying is the mass of solid matter remaining after drying treatment of a solution obtained by the solubility test. Content of water-soluble compound (%) = [(mass of water-soluble compound remaining after drying)/(mass of photosensitive resin composition subjected to water solubility test)] × 100

### <Concentration of solid matter in waste developer>

A waste developer (10 g) wherein a flocculate had been removed therefrom was put in a petri dish and subjected to drying under reduced pressure. The non-volatile content after the drying was represented by mass%. This value was defined as the concentration of solid matter in the waste developer.

### <Concentration of solid matter in recycled developer>

A recycled developer (10 g) wherein a flocculate had been removed therefrom was put in a petri dish and subjected to drying under reduced pressure. The non-volatile content after the drying was represented by mass%. This value was defined as the concentration of solid matter in the recycled developer.

### <Removal rate of solid matter>

The removal rate of solid matter was calculated from the concentration of solid matter in a waste developer and the concentration of solid matter in a recycled developer according to the following formula. Removal rate of solid matter (%) = [(concentration of solid matter in waste developer) - (concentration of solid matter in recycled developer)] / (concentration of solid matter in waste developer) × 100

### <Developing speed>

Printing original plates produced in each of Examples and Comparative Examples were developed using a fresh developer (which had never been used for development of original plates) and a recycled developer produced in each of Examples and Comparative Examples so as to measure a distance in which each of the printing plates was washed in its depth direction for 10 minutes. The development using a fresh developer is intended to examine the effect of reducing a developing time caused by allowing a photosensitive resin composition to contain a water-soluble compound. It can be said that when a developing speed in the development using a fresh developer is higher, a developing time is more reduced. On the other hand, the development using a recycled developer is intended to examine the degree of reduction in the developing speed of a waste developer due to a water-soluble compound eluted into the developer by development using a fresh developer. It can be said that when a developing speed in the development using a recycled developer is higher, a water-soluble compound has been less eluted into the developer, and the degree of reduction in the developing speed of a waste developer is low. It should be noted that the developing speed is regarded as excellent when it is 0.5 mm/10 min or higher.

### <Image reproducibility>

Development was performed using each of the recycled developers produced in the Examples and the Comparative Examples. The diameter of the smallest independent dot reproduced by a developed printing plate was measured, and was evaluated by the following criteria.
∘: Diameter of 200 µm was reproduced.
Δ: Diameter of 300 µm was reproduced.
×: Diameter of 400 µm was not reproduced.

### <Presence or absence of resin attached to surface of printing plate>

Development was performed using each of the recycled developers produced in the Examples and the Comparative Examples. The presence or absence of a flocculate attached to the surface of an obtained printing plate was determined by visual inspection, and was evaluated by the following criteria.
∘: Attachment to surface of plate was not observed.
×: Attachment to surface of plate was observed.

Details of components used for photosensitive resin compositions of Examples and Comparative Examples are as follows.

### [Hydrophobic polymer]

A1: Butadiene latex (Nipol LX111A2, manufactured by Zeon Corporation, non-volatile content 54.0%)
A2: Acrylonitrile-butadiene rubber emulsion (Nipol 1562, manufactured by Zeon Corporation: amount of bonded AN 33.5 mass%, emulsion with a concentration of 41 wt%)
A3: Styrene-butadiene latex (Nalstar SR-101, manufactured by NIPPON A&L INC., degree of gelation 95%, average particle diameter 0.13 µm, non-volatile content 46%)
A4: Styrene butadiene block copolymer (KRATON DX410, manufactured by Kraton Corporation: styrene content 18%, butadiene content 82%)

### [Hydrophilic polymer]

B1: Carboxy-modified nitrile butadiene latex (Cyatex NA-106, manufactured by NIPPON A&L INC., degree of gelation 45%, average particle diameter 0.14 µm, solid matter concentration 50%)
B2: Carboxy-modified styrene-butadiene latex (Nalstar SR-101, manufactured by NIPPON A&L INC., degree of gelation 95%, average particle diameter 0.24 µm, solid matter concentration 52%)
B3: Carboxy-modified styrene-butadiene latex (Nalstar SR-112, manufactured by NIPPON A&L INC., degree of gelation 70%, average particle diameter 0.13 µm, solid matter concentration 50%)
B4: Carboxy-modified styrene-butadiene latex (Nalstar SR-140, manufactured by NIPPON A&L INC., degree of gelation 60%, average particle diameter 0.15 µm, solid matter concentration 48%)
B5: An emulsion polymerization liquid of a carboxy-modified styrene-butadiene polymer produced by a production method described below
B6: A ureaurethane-based hydrophilic polymer solution produced by a production method described below

### [Production method of hydrophilic polymer B5]

Polymerization was performed using a monomer mixture containing 57 parts by mass of butadiene, 15 parts by mass of styrene, 20 parts by mass of ethyl acrylate, 3 parts by mass of methacrylic acid, and 5 parts by mass of acrylic acid in accordance with a production example described in Japanese Patent No. 3836433 except for a compositional ratio. After the completion of a polymerization reaction, cooling was performed. Then, a generated copolymer latex was adjusted to pH 7 with sodium hydroxide, an unreacted monomer was removed by steam stripping, and filtration was performed using a 200-mesh wire mesh. In this way, a final solid matter concentration was adjusted to 40 mass% to obtain an emulsion polymerization solution of a hydrophilic polymer B5.

### [Production method of hydrophilic polymer B6]

Firstly, 60.0 parts by mass of hexamethylene diisocyanate, 31.0 parts by mass of dimethylol propionic acid, 15.0 parts by mass of polytetramethylene glycol having a molecular weight of 850, and 3.0 parts by mass of di-n-butyl tin dilaurate were dissolved in 150 parts by mass of tetrahydrofuran to obtain a solution, and the solution was placed in a 1-liter flask equipped with a stirrer and was subjected to a reaction for 2 hours by heating to 65°C with stirring. In another container, 92.0 parts by mass of an acrylonitrile-butadiene oligomer having an amino group at its terminal (HycarATBN 1300×16, manufactured by UBE Corporation) was dissolved in 135 parts by mass of tetrahydrofuran to obtain a solution. The solution was added to the 1-liter flask with stirring at room temperature. The tetrahydrofuran was distilled off from the polymer solution under reduced pressure, and drying was performed under reduced pressure to obtain a polymer having a number-average molecular weight of 8500. Then, 25 parts by mass of the polymer was dissolved in 33 parts by mass of tetrahydrofuran to obtain a solution, and an aqueous solution obtained by dissolving 0.6 part by mass of lithium hydroxide and 1.4 parts by mass of magnesium acetate in 42 parts by mass of ion-exchange water was added to the solution with stirring at room temperature to obtain a ureaurethane-based hydrophilic polymer B6 having a solid matter concentration of 25 mass%.

### [Photopolymerizable unsaturated compound]

C1: Polybutadiene-terminated diacrylate (BAC-45, manufactured by OSAKA ORGANIC CHEMICAL INDUSTRY LTD.)
C2: 3-Methyl-1,5-pentanediol diacrylate (manufactured by Tokyo Chemical Industry Co., Ltd.)
C3: 1,10-Decane diacrylate (article number A-DOD-N, manufactured by SHIN-NAKAMURA CHEMICAL Co., Ltd.)
C4: Tricyclodecane dimethanol diacrylate
C5: Polyethylene glycol #200 diacrylate (A-200, manufactured by SHIN-NAKAMURA CHEMICAL Co., Ltd.)
C6: Glycerol dimethacrylate (Manufactured by Tokyo Chemical Industry Co., Ltd.)
C7: Stearyl acrylate (Manufactured by OSAKA ORGANIC CHEMICAL INDUSTRY LTD.)
C8: Dimethylaminoethyl methacrylate (manufactured by MITSUBISHI GAS CHEMICAL COMPANY INC.)
C9: Glycerin monoacrylate (BLEMMER GLM, manufactured by NOF CORPORATION)

### [Plasticizer]

D1: Liquid butadiene (L-SBR-361, manufactured by Kuraray Co., Ltd.)
D2: Liquid styrene butadiene (L-SBR-841, manufactured by Kuraray Co., Ltd.)

### [Photopolymerization initiator]

Benzyl dimethyl ketal (Manufactured by Tokyo Chemical Industry Co., Ltd.)

### [Other additives]

Heat stabilizer: 4-methoxyphenol (Manufactured by Tokyo Chemical Industry Co., Ltd.)
UV absorber: Tinuvin 326 (Manufactured by Tokyo Chemical Industry Co., Ltd.)

### (Example 1)

### Preparation of photosensitive resin composition

Firstly, 27.5 parts by mass of a butadiene latex (A1) that was a hydrophobic polymer as solid matter, 24 parts by mass of a carboxy-modified nitrile butadiene latex (B1) that was a hydrophilic polymer as solid matter, 17.5 parts by mass of polybutadiene-terminated diacrylate (C1) that was a photopolymerizable oligomer as a photopolymerizable unsaturated compound, 12 parts by mass of 1,10-decane diacrylate (C3) that was a photopolymerizable monomer as a photopolymerizable unsaturated compound, 12 parts by mass of glycerol dimethacrylate (C6) that was a photopolymerizable monomer as a photopolymerizable unsaturated compound, 5 parts by mass of liquid butadiene (D1) as a plasticizer, 1.5 parts by mass of a photopolymerization initiator, 0.2 part by mass of a heat stabilizer, and 0.01 part by mass of a UV absorber were mixed in a container to prepare a dope. The obtained dope was placed in a heated kneader and a solvent was removed under reduced pressure to obtain a photosensitive resin composition.

### Preparation of flexographic printing original plate

The obtained photosensitive resin composition was sandwiched between a support film obtained by coating a 125 µm-thick polyethylene terephthalate film with a polyester-based adhesive layer and a film obtained by coating the same polyethylene terephthalate cover film with an anti-blocking layer (polyvinyl alcohol). At this time, the adhesive layer and the anti-blocking layer were brought into contact with the photosensitive resin composition. Then, a A2-size flexographic printing original plate was obtained by lamination using a heat press machine at 100°C, which was constituted from a polyethylene terephthalate film support, an adhesive layer, a photosensitive resin layer, an anti-blocking layer, and a cover film. The total thickness of the plate was 1.7 mm.

Then, the obtained flexographic printing original plate was exposed to light (image coverage rate 50%). Development was repeatedly performed under conditions described below using flexographic printing original plates after exposure to obtain a waste developer having a solid matter concentration of 5.0 mass%.

### <Developing device>

A developing device having a structure illustrated in FIG. 1 was used.

### <Developer>

A developer was prepared by weighing sodium oleate in an amount of 1% of the total amount of the developer and dissolving it in tap water. The developer was heated to a liquid temperature of 40°C when used.

### <Development brush>

A development brush was used that was obtained by implanting, under the following conditions, a nylon brush with a diameter of 150 µm in a support plate formed of a 10-mm-thick vinyl chloride chipboard.
Diameter of hole for implanting hair bundle: diameter of 20 mm
Hair-bundle implanting density: density of 120 hairs/hole

Next, the obtained waste developer was transferred from a developing bath 1 shown in Fig. 1 to a stationary tank 4 and left to stand still in the stationary tank 4 for 5 hours so as to emerge and flocculate the photosensitive resin composition contained in the waste developer and thus form a solid-liquid mixed phase containing a flocculate 5 beneath the liquid surface of the waste developer. The volume of the waste developer transferred to the stationary tank 4 is 45 L, and the level of the waste developer in the stationary tank 4 immediately after the transference of the waste developer to the stationary tank 4 was a height corresponding to 75% of the depth of the stationary tank 4.

The stationary tank 4 has a substantially rectangular parallelepiped shape having a dimension of 43 cm (width) × 76 cm (length) × 19 cm (height). A rectangle-shaped outlet 6 having a dimension of 5 cm (height) × 70 cm (length) as illustrated in FIG. 2 is formed on a one-end side surface of the stationary tank. The formation position of the outlet 6 is set such that the lowest position of a rectangular aperture of the outlet is at a height corresponding to 70% of the depth of the stationary tank 4. The outlet 6 has a lid whose upper portion is fixed to a wall surface by a fixing shaft. The lid is openable around the fixing shaft as illustrated in FIG. 4 and 5.

By opening the lid of the outlet 6 after leaving the waste developer to stand still, the solid-liquid mixed phase containing the flocculate 5 was discharged from the outlet 6 and recovered into a flocculate recovery tank 7. Thereafter, a liquid left in the stationary tank 4 was recovered as a recycled developer. The volume of the recovered recycled developer was 35 L. The developing speed, the image reproducibility, and the presence or absence of a flocculate attached to the surface of a printing plate were evaluated using this recycled developer. Table 1 shows the evaluation results.

### Examples 2 to 16, Comparative Examples 1 to 4

Flexographic printing original plates were produced and evaluated in the same manner as in Example 1 except that the blending ratio of the components in the photosensitive resin composition constituting the photosensitive resin layer was changed as shown in Table 1 or Table 2. Tables 1 and 2 show the evaluation results.

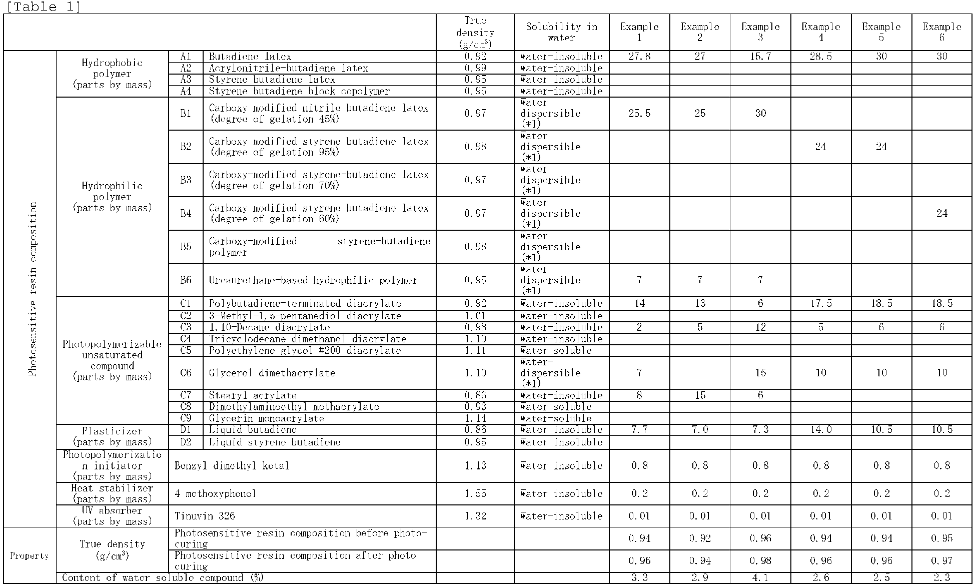

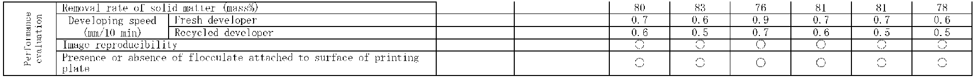

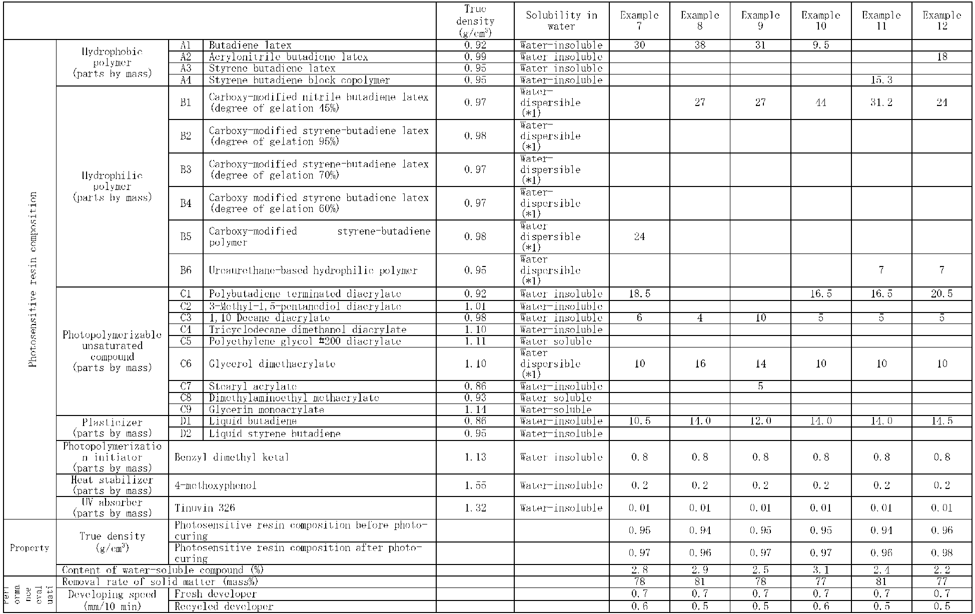

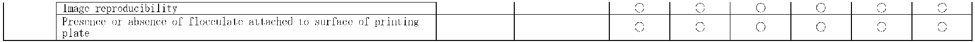

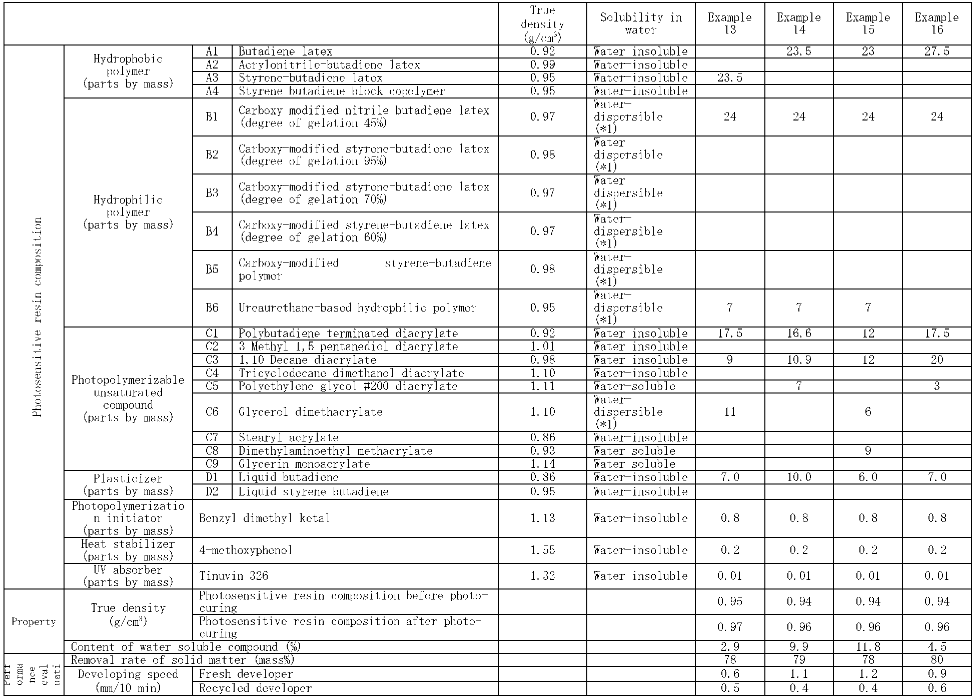

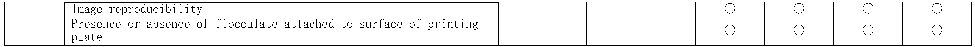

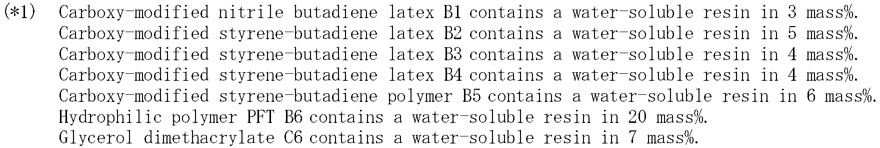

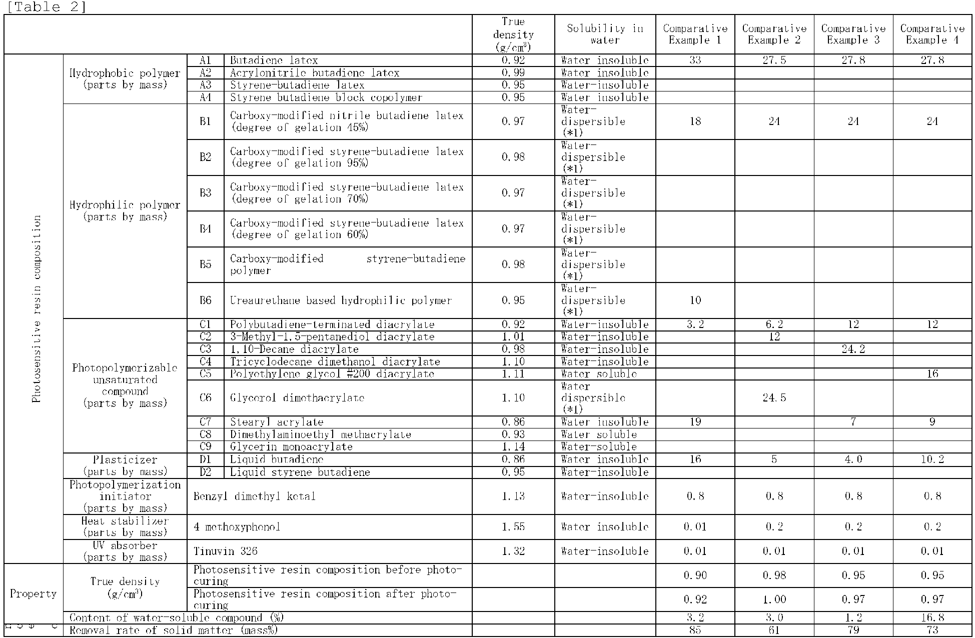

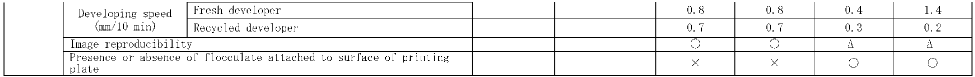

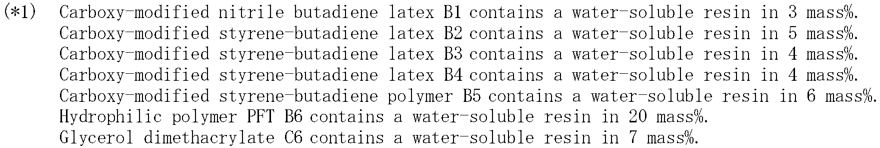

As can be seen from Tables 1 and 2, Examples 1 to 16 satisfying the requirements of the present invention are superior in all of the solid matter removal rate, the developing speed, the image reproducibility, and the presence or absence of flocculate attached to the surface of the printing plate. On the other hand, in Comparative Example 1, the true density of the photosensitive resin composition before photo-curing was too low, and therefore the photosensitive resin composition emerged/flocculated as early as during development of the printing original plates so that flocculate derived from the photosensitive resin composition removed by development was reattached to the surface of the printing plates. In Comparative Example 2, the true density of the photosensitive resin composition before photo-curing was too high, and therefore the difference in specific gravity from water mainly contained in the waste developer was small, and therefore the photosensitive resin composition was less likely to emerge/ flocculate and flocculate could not sufficiently be removed even when the waste developer was left to stand still for 5 hours, which was not practical. Further, the photosensitive resin composition that could not be recovered remained in the recycled developer and was therefore attached to the surface of the printing plates. In Comparative Example 3, the content of the water-soluble compound in the photosensitive resin composition was too low, and therefore the developing speed at the time when a fresh developer was used was low, that is, the effect of reducing a developing time of the printing original plate was poor. Further, the developing speed at the time when the recycled developer was used was also low. In Comparative Example 4, the content of the water-soluble compound in the photosensitive resin composition was too high, and therefore the water-soluble compound in the photosensitive resin composition in an unexposed area was eluted in a large amount into a developer by development using a water-based developer, and therefore the developing speed at the time when the recycled developer was used was significantly reduced.

### Industrial Applicability

According to the method of the present invention, it is possible to produce, from a waste developer generated by development of a water-developable flexographic printing original plate, a high-performance recycled developer that achieves a high developing speed and hardly causes a problem of re-attachment of flocculate onto the surface of a printing plate because a photosensitive resin composition having a true density within a specific range is used and the photosensitive resin composition contains a water-soluble compound in a ratio within a specific range. Accordingly, the present invention is very useful.

### Explanation of Reference Number

1: Developing bath
2: Developer
3: Pipe
4: Stationary tank
5: Flocculate
6: Outlet
7: Flocculate recovery tank
8: Pump
9: Pipe

## Claims

1. A method for producing a recycled developer from a waste developer generated by development of a water-developable flexographic printing original plate having a photosensitive resin layer composed of a photosensitive resin composition containing at least a hydrophobic polymer, a hydrophilic polymer, a photopolymerizable unsaturated compound, a photopolymerization initiator, and a plasticizer, wherein the method comprises the steps of:
leaving the waste developer to stand still in a tank without adding a flocculant to the waste developer so as to allow the photosensitive resin composition contained in the waste developer to emerge/flocculate; and
discharging floating flocculate from the tank so as to obtain a liquid remaining in the tank as a recycled developer, wherein
the photosensitive resin composition has a true density of 0.91 to 0.97 g/cm³ before photo-curing and contains a water-soluble compound in a ratio of 1.5 to 15 mass%.

2. The method according to claim 1, wherein the photosensitive resin composition has a true density of 0.93 to 0.99 g/cm³ after photo-curing.

3. The method according to claim 1, wherein the water-soluble compound is a water-soluble photopolymerizable unsaturated compound selected from the group consisting of one having polyalkylene glycol in its structure, one containing a carboxyl group in its molecule, one containing a hydroxyl group in its molecule, one containing an amino group in its molecule, and a mixture of them.

4. A method for producing a water-developable flexographic printing plate, wherein the method comprises using, as a developer, the recycled developer obtained by the method according to any one of claims 1 to 3.

5. A photosensitive resin composition for water-developable flexographic printing original plate containing at least a hydrophobic polymer, a hydrophilic polymer, a photopolymerizable unsaturated compound, a photopolymerization initiator, and a plasticizer, wherein the photosensitive resin composition has a true density of 0.91 to 0.97 g/cm³ before photo-curing and contains a water-soluble compound in a ratio of 1.5 to 15 mass%.

6. A water-developable flexographic printing original plate having a support and a photosensitive resin layer, wherein the photosensitive resin layer is composed of the photosensitive resin composition for water-developable flexographic printing original plate according to claim 5.
